# EUROPEAN PATENT SPECIFICATION

(11) **EP 1 682 691 B1**
(45) Date of publication and mention of the grant of the patent: **11.01.2017**
(21) Application number: 04800266.1
(22) Date of filing: 03.11.2004
(51) Int. Cl.: C23C 28/02, C23C 28/00, C23C 14/16, C23C 14/30, C23C 14/56, C23C 30/00

(54) **METHOD FOR PRODUCING A STAINLESS STEEL STRIP COATED WITH A METALLIC LAYER**
VERFAHREN ZUR HERSTELLUNG EINES MIT EINER METALLSCHICHT BESCHICHTETEN BANDS AUS NICHTROSTENDEM STAHL
PROCEDE DE PRODUCTION D'UNE BANDE D'ACIER INOXYDABLE REVETUE D'UNE COUCHE METALLIQUE

(30) Priority: 04.11.2003 SE 0302902
(43) Date of publication of application: 26.07.2006
(73) Proprietor: Sandvik Intellectual Property AB, 811 81 Sandviken (SE)
(72) Inventor: HOLMBERG, Hakan, S-802 69 Gävle (SE)
(86) International application number: PCT/SE2004/001603
(87) International publication number: WO 2005/042797

(56) References cited:
- EP-A1- 0 570 618
- WO-A1-2005/014876
- US-A- 4 763 601
- US-A- 5 429 843
- PATENT ABSTRACTS OF JAPAN vol. 014, no. 334 18 July 1990 & JP 02 122 064 A (SUMITOMO METAL IND LTD) 09 May 1990

## Description

The present invention relates to a method for a spring element of a switch, a connector or metallic dome in accordance with the preamble of claim. This is achieved by coating a metallic strip with an electrically conductive layer, in accordance with claim 1.

### Background of the Invention

In many electronic devices such as telephones, remote controls, computers, etc., springs and other formed metallic parts are used for different functions. Hence, for electromagnetic shielding (EMS) purposes, springs are used in so called "finger stocks"as gaskets in removable sections in shielded boxes. In most such products, several different requirements on the material are at hand. For springs, the requirements are in general related to the mechanical behavior such as force, relaxation resistance, and fatigue resistance. However, as forming is generally involved, the material must be able to be formed to requested shapes without any cracking. Further, the ongoing miniaturization within this field also puts increasing demands on tight geometrical tolerances of components and parts in electronic devices. In addition to the above, it is sometimes crucial to have well defined electrical characteristics of such parts and components. This may involve specific properties regarding electrical conductivity or contact resistivity at interfaces within devices. Generally, when such requirements are present, the solution is to choose a conductive material such as copper or copper alloys, or alternatively to coat a steel with a conductive layer. Copper and copper alloys are often characterized by good electrical conductivity and good formability but most of them are suffering from low mechanical strength, which means that they are not suitable for applications that are highly stressed, as for instance springs. Alloys of copper and beryllium may be hardened to a tensile strength up to approximately 1400 MPa but also this tensile strength level limits the spring force, fatigue and relaxation resistance that can be achieved for spring applications. Further, beryllium is a toxic metal, which may put restrictions during manufacturing and use due to health considerations. Finally, copper-beryllium alloys are costly and, therefore, less expensive products are requested in many applications.

Coating may be carried out by various methods that can be divided into mechanical and chemical methods. These may also be sub-divided into high and low temperature methods. Mechanical methods may be exemplified by cladding, thermal by spraying or painting. In this context, cladding is represented by roll bonding, i. e. , to bind two (or more) different materials by a rolling process that is relatively simple and may be carried out with different combinations of substrates and coatings. However, cladding suffers from some technical disadvantages, which are related to thickness tolerances and poor adhesion of the coated layer. This often requires a post-bonding heat treatment in order to obtain a diffusion zone between layers. If one (or several) of the layers is/are stainless steel, then a good adhesion is even more difficult to obtain due to the passive film at the stainless surface. Further, roll bonding is a low speed process and is limited in the possible combinations of base materials and coatings.

There also exist numerous different deposition techniques based on spraying methods with different names such as Thermal Spray, High Velocity Oxide Fuel (HVOF), Plasma Spray, Combustion Chemical Vapor Deposition (CCVD); however, the underlying method is the same. The coating is sprayed onto a substrate and the material is fed into the nozzle or "flame" from either a rod, wire, stock, powdered material, liquid or gas. Spray techniques are most often used to coat details and are not suitable for roll-to-roll coatings, with high requirements on close tolerances and high productivity.

Another method to coat a substrate is by hot dipping of the product into a molten metal. Hot dipping is generally carried out with coatings that have a low melting point, e. g. , zinc, etc. For coatings with higher melting points, such as nickel and copper, the temperature of the molten metal is so high that it will often affect the substrate material in a negative way. Further, to have an accurate process control of such molten bath allowing close tolerances on layer thickness, is difficult.

Electroplating is an electrochemical process in which the coating is achieved by passing an electrical current through a solution containing dissolved metal ions and the metal object to be plated. The metal substrate serves as the cathode in an electrochemical cell, attracting metal ions from the solution. Ferrous and non-ferrous metal substrates are plated with a variety of metals, including aluminum, brass, bronze, cadmium, copper, chromium, iron, lead, nickel, tin, and zinc, as well as precious metals, such as gold, platinum, and silver.

As the substrate acts as a cathode in the process and thereby attracts the ions in the solution, it is difficult for flat products to obtain an even layer distribution. Local variations in current density will create an inhomogeneous deposition rate. A well-known problem is the "dog bone" effect that means that the thickness of the coating is often higher towards the edges of a coated strip. Further, the method is characterized by not being environmentally friendly as it involves electrolytes and costly wastewater treatment. Electrochemical methods and dipping methods also have the disadvantage that if a single sided coating is requested, the surface that shall remain uncoated has to be masked in some way prior to the coating. The masking then has to be removed subsequent to the coating operation.

There are also some vapor deposition methods that can be used for depositing metals. Most methods are batch-like processes, but there are also some continuous processes. One example of a roll-to-roll method making use of electron-beam deposition is disclosed in WO 98/08986, which describes a method of manufacturing ferritic stainless FeCrAl-steel strips, by bringing about an aluminum coating of a substrate material in a roll-to-roll process. However, the method described in this patent application is optimized for a product suitable for use in a high temperature corrosive environment, thus requiring a material with a good high-temperature strength and also a good high-temperature corrosion resistance, i. e. , oxidation resistance. Moreover, this patent application suggests that a homogenization annealing at a temperature of 950-1150 °C is made in connection to the coating, in order to have the aluminum evenly distributed in the ferrite. This means that the final product in this case is not a coated product with an aluminum layer on the surface. Hence, it is rather a FeCrAl strip product with a uniform distribution of the alloying elements, including also aluminum. Further, this means that there are no special requirements on an oxide free interface and on a good adhesion of the layer.

JP63072869 discloses that a foil coated with a layer of Ag, Au or Cu, deposited by means of vacuum deposition sputtering, ion plating or other method could be used as a spring for a switch contact. However, vacuum deposition is a generic definition of a number of deposition methods having in common that the deposition takes place in vacuum.

WO2005/014876 A1 discloses a coated steel strip product with a dense and hard abrasion resistant coating on one side or both sides of said strip. The thickness of said coating is in total maximally 25 µm, the hardness of said coating is at least 600 HV and the tensile strength of the steel strip substrate is at least 1200 MPa. The coating is preferably applied by electron beam evaporation and the coating may be, e.g., of Al₂O₃ . The coated metal strip is useful for the manufacturing of doctor and coater blades for paper and printing industry. Thus, the properties and the use of the coated steel strip product are different from the present disclosure.

US 4763601 A discloses a continuous composite coating apparatus for coating a continuous strip. The apparatus has a pair of strip supply/take-up devices and at least two of a plasma chemical vapor deposition coating zone, an ion-plating coating zone and a sputtering coating zone which are arranged in series along the path of said strip between the strip supply/take-up devices. The coating zones are arranged to effect coating only on the underside of the strip which is not contacted by the guide rollers, whereby a coating layer having excellent properties without any defect can be formed on the underside of the strip.

Thus, all these conventional methods are suffering from different disadvantages, which means that there is a need for a development of a new product combining good mechanical properties with excellent electrical characteristics and narrow geometrical tolerances. All processes based on batch-type production will always increase the cost and it is therefore essential that the production will be by a roll-to-roll process to decrease the cost.

Therefore, it is a primary object of the present invention to provide a flexible metallic product with tailor-made physical and mechanical characteristics suitable for further processing that may be exemplified by, but not limited to, blanking, bending, drilling, heat treatment etc.

Yet another object of the present invention is to provide a flexible strip product, for springs and other products, that requires a good electrical conductivity, made from a single-or multilayered metallic strip that is inexpensive and which may be produced in a continuous roll-to-roll process.

These and other objects have been attained in a surprising manner by creating a coated steel products by the method as defined in claim 1. Further preferred embodiments are defined in the dependent claims.

### Brief Description of the Invention

Thus, the above objects and further advantages are achieved by applying one or more thin continuous, uniform, electrically conductive layer (s) of a metal, such as nickel, silver, tin, molybdenum, copper, tungsten, gold or cobalt, on the top of a metal stainless strip serving as substrate. The coating may be done on one or both sides of the substrate strip in accordance with the teaching of claim 1. The metal layer should be smooth and dense and have a good adhesion in order to allow for further processing without the risk of flaking or peeling. The final product, in form of a high strength strip steel with one or two electrically conductive surfaces, is suitable for use in electrical devices, in gaskets for electromagnetic shielding or for any other purpose, where a high strength material with a low contact resistance in the interface between the product according to the invention and its contact point is requested.

The coated layer is deposited by means of the previously known method electron beam evaporation (EB), in a roll-to-roll process, to an evenly distributed layer with a thickness of preferably less than 15 µm. The substrate material should be a stainless steel with a Cr content above 10% (by weight) and with a strip thickness of usually less than 3 mm. The substrate material should have a tensile strength of at least 1000 MPa, which can be achieved by cold deformation or by thermal treatment such as hardening from high temperature or by precipitation hardening at lower temperatures. As a first step, the roll- to-roll process may also include an etch chamber, in order to remove the oxide layer that otherwise normally is present on a stainless steel.

### Brief Description of the Drawings

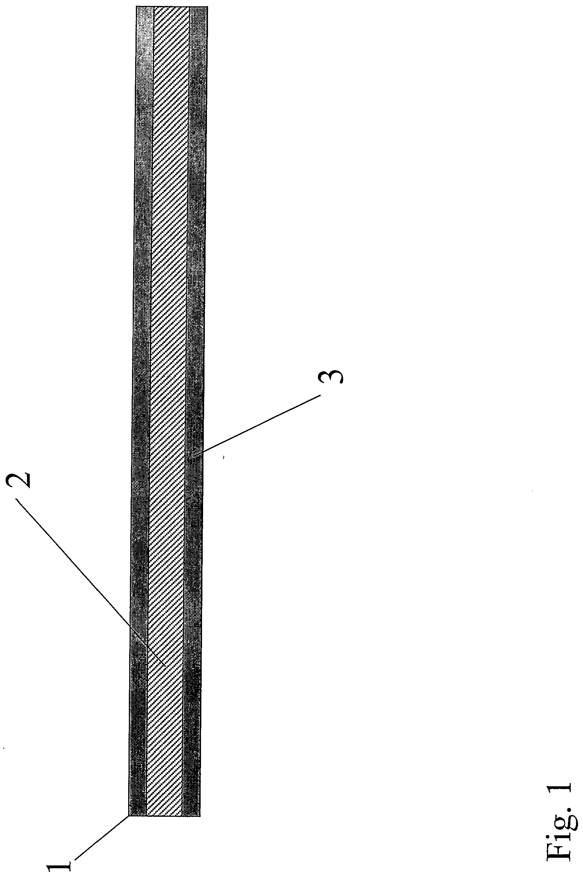

Figure 1 shows a schematic cross-section of a substrate strip 2 with a coating of an electrically conductive layer 1,3 on one or both surfaces. If the substrate is coated on both surfaces, then the coatings may be of the same composition, or if so desired, of different compositions. Also the thickness of the coating may be the same or different for the two surfaces.

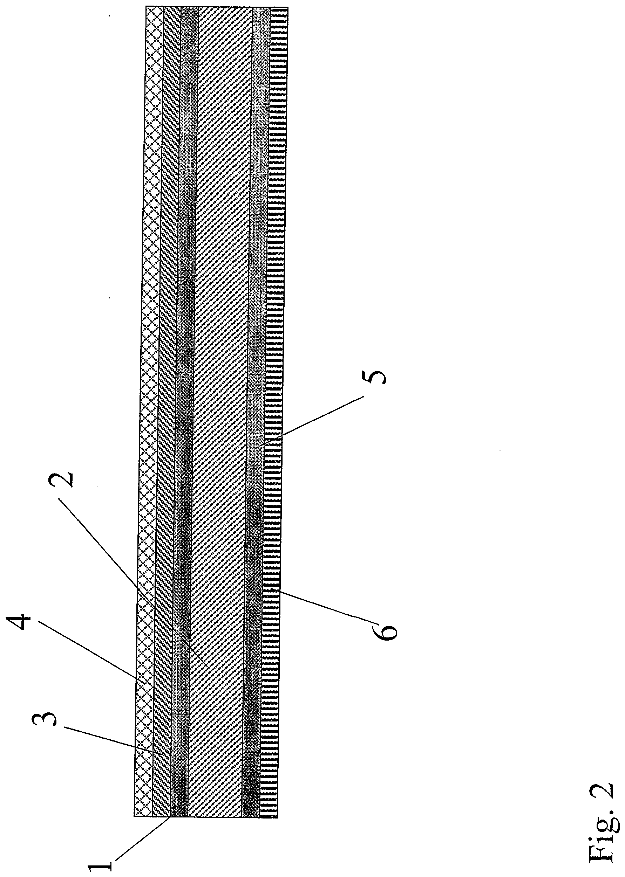

Figure 2 shows a schematic cross-section of a substrate strip 2 with coatings of multiple layers (1,3, 4 and 5,6, respectively) on one or both surfaces.
Figure 3 shows schematically a production line for the manufacturing of a coated metal strip material according to the invention.

### Detailed Description of the Invention

The final product, in the form of a metal coated strip material, is suitable for the use as load carrying parts that also are characterized by providing a low contact resistance at the interface. Examples of such applications are connectors and switches. By applying a given force on the spring, it will contact a surface and thus close an electrical circuit. At the point of contact, where the current is transferred, it is important that the contact resistance is low. Stainless steel is an increasingly used material for spring applications. This is due to the attractive combination of high mechanical strength and good formability, allowing forming also rather complex spring geometries. High strength stainless spring steels have in general superior mechanical properties compared to nonferrous materials. In the context of spring properties, especially the fatigue and relaxation resistance of high strength stainless steel are crucial for a long lasting spring with a constant force throughout its service life. However, stainless steel is characterized by a passive film on the surface. This film consists of chromium oxide and has a significantly lower electrical conductivity than the steel itself. As a reference value, stainless steel has an electrical resistivity of 80-90 x 10⁻⁸ Qm, depending on the tensile strength. However, at the surface, the oxide (Cr₂O₃), has a resistivity of approximately 1,3 x 10¹¹ Ωm. If an oxide film is present at the interface between two conductive surfaces, a drop in conductivity will occur.
This will decrease the efficiency in current circulation in the circuit and thus decrease the performance.

To eliminate the problem of low conductivity in high strength stainless steel, at least one of the strip surfaces is coated with a metal layer that is less prone to form an oxide film at the surface. The coated layer will thus allow for an oxide free surface at the contact point, whereby the drop in electrical conductivity at the interface is avoided. Depending on the requirements, the coating may be of different metals. Silver, copper, nickel, cobalt, gold, tungsten, tin and molybdenum are all metals with a good electrical conductivity that may be deposited on the surface by the method according to the invention. It is also of vital importance that the coating is homogeneously distributed on the surface and is not too thick compared to the substrate thickness. A thick or an uneven layer will affect the spring properties, as the bending force is proportional to the thickness of a rectangular section raised to the third power. The thickness of the layer is therefore preferably max 10% of the substrate thickness. Moreover, the thickness of each coating layer is preferably maximally 15 µm, typically 0, 05-15 µm, preferably 0,05-10 µm and even more preferably 0, 05-5 µm. If multiple layers are to be deposited, then the total summarized thickness of the coatings should not exceed +/- 20% of the total thickness of the coated strip. The thickness tolerance of the coated layer according to the invention is very good. The variation in thickness of and within each layer should not exceed +/- 20% of the nominal thickness of said layer. More preferably, the thickness variation should be maximum +/- 10% of the nominal thickness within each layer.

The coating should show a good adhesion to the substrate and thus make subsequent manufacturing possible. The product achieved by the method according to the invention shows an excellent adhesion between the coating and the substrate. This is achieved by a pretreatment operation of the stainless strip by means of an ion etching in vacuum prior to the deposition of the coating on the substrate. This allows for a metal-metal contact with an oxide free interface that will give a product that may be bent, blanked, slit or deep-drawn, the only limit being set by the ductility of the substrate material.

### The Substrate Strip to be Coated

The material that shall be coated should have a good general corrosion resistance. This means that the material must have a chromium content of at least 10% by weight, preferably minimum 12% or more preferably minimum 13% or most preferably minimum 15% chromium. Further, the material must be alloyed in a way that allows for a high tensile strength of at least 1000 MPa, more preferably a minimum of 1300 MPa or even more preferably minimum 1500 MPa, or most preferably a minimum of 1700 MPa. The mechanical strength may be achieved by cold deformation such as for steels of the ASTM 200 and 300 series, or by thermal hardening as for hardenable martensitic chromium steels. Other suitable substrate materials are precipitation hardenable (PH) steels of type 13-8PH, 15-5PH, 17-4PH or 17-7PH. Yet another group of suitable substrate materials are stainless maraging steels that are characterized by a low carbon and nitrogen containing martensitic matrix that is hardened by the precipitation of substitutional atoms such as copper, aluminum, titanium, nickel etc.

### The Conductive Layer(s)

The material to be coated in the form of a thin layer film on the substrate surface should be characterized by a good electrical conductivity at room temperature, a thermodynamic stability against oxide formation and a suitable modulus of elasticity. The characteristics of the suitable elements are listed below.

**Silver** has a very low electrical resistivity, approximately 1, 47x10⁻⁸ Qm, at room temperature. The free energy for oxide formation for Ag₂O at room temperature is approximately AG =-10,7 kJ which makes silver significantly more stable against oxidation compared with the formation of Cr₂O₃, as in stainless steel. As a reference value, Cr₂O₃ has a free energy at room temperature of approximately AG =-1050 kJ. Silver has a modulus of elasticity of approximately 79000 MPa that can be compared to the 180.000-220.000 MPa for different steel types. Silver is however relatively expensive and sometimes cheaper alternatives are required.

**Copper** has a low electrical resistivity of approximately 1,58 x 10⁻⁸ Qm, a modulus of elasticity of approximately 210.000 MPa and a free energy of ΔG =-145 kJ and ΔG =-127 kJ for the formation of Cu₂O and CuO respectively. This combination of properties makes also copper a suitable coating in the method according to the invention.

**Nickel** has a low electrical resistivity of approximately 6,2 x 10⁻⁸ Qm, a modulus of elasticity of 200.000 MPa and a free energy of approximately ΔG =-213 kJ for the formation of NiO.

**Gold** has an electrical resistivity of approximately 2 x 10⁻⁸ Qm, a modulus of elasticity of 80.000 MPa. Gold is also extremely stable against oxidation. This makes gold in many applications most suitable as an element for conductive coatings. However, gold is expensive and alternatives are always looked for due to the high alloy cost as well as re-cycling costs.

**Molybdenum** has a low electrical resistivity of approximately 5,3 x 10⁻⁸ Qm, a modulus of elasticity of 329.000 MPa and a free energy of approximately ΔG =-668 kJ for the formation of MoO₃ and ΔG =-533 kJ for the formation of MoO₂.

**Cobalt** has a low electrical resistivity of approximately 6,24 x 10⁻⁸ Qm, a modulus of elasticity of 209.000 MPa and a free energy of approximately ΔG =-241 kJ for the formation of CoO.

**Tungsten** has a low electrical resistivity of approximately 5,3 x 10⁻⁸ Qm, a modulus of elasticity of 360.000 MPa and free energies of approximately ΔG =-534 kJ and ΔG =-764 for the formation of WO₂ and WO₃, respectively.

**Tin** has an electrical resistivity of approximately 10 x 10⁻⁸ Qm and a modulus of elasticity of 50. 000 MPa. The free energy to form SnO is approximately ΔG =-534 kJ at room temperature. Tin is also a relatively soft metal and is easily deformed at the point of contact and may by this generate a larger contact area at the interface. This may be utilized, e.g. , in gasket springs for electromagnetic shielding.

### Description of Coating Method

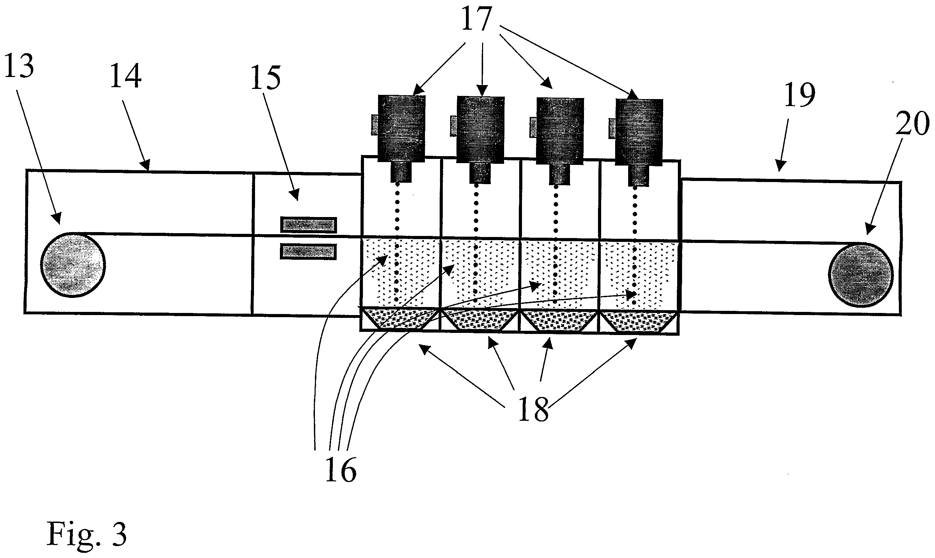

The coating method is integrated in a roll-to-roll strip production line. In this roll-to-roll production line, the first production step is an ion- assisted etching of the metallic strip surface, in order to achieve good adhesion of the first layer. The conductive layer is deposited by means of electron beam evaporation (EB) in a roll-to-roll process. The formation of multi- layers can be achieved by integrating several EB deposition chambers in-line (see Figure 3).

### Preferred Embodiment of the Invention

Two examples of embodiments of the invention will now be described in more detail. One example is based on a silver coating on an ASTM 301-type of steel with a chemical composition of max 0,12% C, max 1,5% Si, max 2% Mn, 16-18% Cr and 6-8% Ni with balance Fe and residual elements that are present according to the metallurgical method used. The second example is a nickel coating on a modified ASTM 301-type of steel with a chemical composition of max 0,12% C, max 1,5% Si, max 2% Mn, 16-18% Cr and 6-8% Ni, 0,5-1,0% Mo with balance Fe and residual elements that are present according to the metallurgical method used.

Firstly, the substrate materials are produced by ordinary metallurgical steel-making to a chemical composition as exemplified above. They are then hot rolled down to an intermediate size, and thereafter cold-rolled in several steps with a number of recrystallization steps between said rolling steps, until a final thickness of about 0,02-1 mm and a width of maximum 1000 mm are attained. The surface of the substrate material is then cleaned in a proper way to remove all oil residuals from the rolling.

Thereafter, the coating process takes place in a continuous process line, starting with decoiling equipment. The first step in the roll-to-roll process line can be a vacuum chamber or an entrance vacuum lock followed by an etch chamber, in which ion-assisted etching takes place in order to remove the thin oxide layer on the surface of the stainless substrate material. The strip then enters into the E-beam evaporation chamber (s) in which the deposition of the desired layer takes place. A metal layer of normally 0,05 up to 15 µm is deposited, the preferred thickness depending on the application. In the two examples described here, a thickness of 0,2-1,5 µm is deposited by using one E-beam evaporation chamber.

After the EB evaporation, the coated strip material passes through the exit vacuum chamber or exit vacuum lock before it is coiled on to a coiler. The coated strip material can now, if needed, be further processed by, for example, rolling or slitting, to obtain the preferred final dimension for the manufacturing of components.

The final product as described in the two examples, i. e., a 0,05 mm thick strip of ASTM 301 with a single sided 1,5 µm Ag-coating and a 0,07 mm thick strip of ASTM 301, modified with a single sided 0,2 µm Ni-coating, have a very good adhesion of the coated layer and are thus suitable to be used in subsequent manufacturing of components for high strength applications, e. g. for springs. The good adhesion of the layers is tested according to standard tensile testing. From a substrate material of a stainless steel strip that has been coated with a thin covering layer so as to produce a coated strip product in accordance with the present invention, tensile test specimens are produced according to standard. Tensile testing of 4 specimens, for example according to EN 10002-1, is thereafter carried out until fracture. After testing, the fractured part of the specimen is investigated in an optical microscope with a magnification of 50 times. Beside the actual fracture from testing, no signs of flaking, peeling or any other damage of the coated layer has been observed in any tested specimen. The results from this test are presented in Table 1.

**Table 1. Mechanical properties and adhesion of layer.**

| *Sample* | *Thickness Mm* | Proof strength Rp 0.05% MPa | Proof strength Rp0.2% MPa | Tensile strength Rm MPa | Visual Examination at 50 times magnification |
|---|---|---|---|---|---|
| 301+Ni | 0,07 | 1659 | 2108 | 2120 | No peeling or flaking |
| 301Mod+ Ag | 0,05 | 1445 | 1920 | 1945 | No peeling or flaking |

The roll-to-roll electron beam evaporation process referred to above is illustrated in Figure 3. The first part of such a production line is the uncoiler 13 within a vacuum chamber 14, then the in-line ion assisted etching chamber 15, followed by a series of EB evaporation chambers 16, the number of EB evaporation chambers needed can vary from 1 up to 10 chambers, this to achieve a multi-layered structure, if so desired. All the EB evaporation chambers 16 are equipped with EB guns 17 and suitable crucibles 18 for the evaporation. After these chambers, comes the exit vacuum chamber 19 and the recoiler 20 for the coated strip material, the recoiler being located within vacuum chamber 19. The vacuum chambers 14 and 19 may also be replaced by an entrance vacuum lock system and an exit vacuum lock system, respectively. In the latter case, the uncoiler 13 and the coiler 20 are placed in the open air.

## Claims

1. A method of producing a spring element of a switch, a connector or metallic dome, in which a stainless steel strip product is coated with a dense and evenly distributed layer on one side or both sides of said 5 strip by means of electric beam evaporation (EB) in a continuous roll-to-roll process, in which the coating process takes place in a continuous process line, in which ion-assisted etching of the strip takes place in an etch chamber, which is followed by an E-beam evaporation chamber in which the deposition of said layer takes place, wherein
- said layer consists of one or several of the metals gold, copper, nickel, molybdenum, cobalt, silver, tin or tungsten,
- the thickness of the strip substrate is between 0,015 mm and 3,0 mm,
- the thickness of said layer is maximally 15 µm and
- the Cr content of the steel strip substrate is at least 10% (by weight),
***characterized in that***
the strip substrate has a minimum tensile strength of 1000 MPa in the cold rolled or heat treated condition.

2. A method according to claim 1 ***characterized in that*** the strip substrate has a tensile strength of at least 1300 MPa.

3. A method according to claim 1 ***characterized in that*** the strip substrate has a tensile strength of at least 1700 MPa.

4. A method according to any one of claims 1 to 3, ***characterized in that*** said strip substrate is made of austenitic stainless steel, or duplex stainless steel, or hardenable martensitic chromium steel, or precipitation hardenable stainless steel, or maraging steel.

## Patentansprüche

1. Ein Verfahren zur Herstellung eines Federelements eines Schalters, eines Steckers oder einer Metallkuppel, in dem ein Edeistahl-Bandprodukt mit einer dichten und gleichmäßig verteilten Schicht auf einer oder auf beiden Seiten des Bandes mittels Elektronenstrahl-Verdampfung (EB) in einem kontinuierlichen Rolle-zu-Rolle-Verfahren beschichtet wird, in welchem der Beschichtungsprozess in einer kontinuierlichen Prozesslinie stattfindet, in der ionengestütztes Ätzen des Bandes in einer Ätzkammer erfolgt, gefolgt von einer Elektronenstrahl-Verdampfungskammer, in der die Ablagerung der Schicht erfolgt, worin:
- die Schicht aus einem oder mehreren der Metalle Gold, Kupfer, Nickel, Molybdän, Kobalt, Silber, Zinn oder Wolfram besteht,
- die Dicke des Bandsubstrates zwischen 0,015 mm und 3,0 mm liegt,
- die Dicke der Schicht maximal 15 µm beträgt, und
- der Cr-Gehalt des Stahlband-Substrats mindestens 10 (Gewichts-) % beträgt,
**dadurch gekennzeichnet, dass**
das Bandsubstrat eine Zugfestigkeit von mindestens 1000 MPa im kalt gewalzten oder wärmebehandelten Zustand besitzt.

2. Ein Verfahren gemäß Anspruch 1, **dadurch gekennzeichnet, dass** das Bandsubstrat eine Zugfestigkeit von mindestens 1300 MPa besitzt.

3. Ein Verfahren gemäß Anspruch 1, **dadurch gekennzeichnet, dass** das Bandsubstrat eine Zugfestigkeit von mindestens 1700 MPa besitzt.

4. Ein Verfahren nach einem der Ansprüche 1 - 3, **dadurch gekennzeichnet, dass** das Bandsubstrat aus austenitischem Edelstahl oder Duplex-Edelstahl, oder aus härtbarem martensitischem Chromstahl, oder ausscheidungshärtendem Edelstahl oder martensitaushärtendem Stahl hergestellt ist.

## Revendications

1. Procédé de fabrication d'un élément ressort d'un commutateur, d'un connecteur ou d'un dôme métallique, dans lequel un produit de bande en acier inoxydable est revêtu d'une couche dense répartie uniformément sur un côté ou les deux côtés desdites 5 bandes au moyen d'une évaporation à faisceau électrique (EP) dans un procédé à rouleaux continu, dans lequel le procédé de revêtement a lieu dans une ligne de procédé continue, dans lequel une attaque assistée par ions de la bande a lieu dans une chambre d'attaque, qui est suivie d'une chambre d'évaporation à faisceau E dans laquelle le dépôt de ladite couche a lieu, dans lequel
- ladite couche est constituée d'un ou plusieurs métaux parmi l'or, le cuivre, le nickel, le molybdène, le cobalt, l'argent, l'étain ou le tungstène,
- l'épaisseur du substrat de bande vaut entre 0,015 mm et 3,0 mm,
- l'épaisseur de ladite couche vaut au maximum 15 µm, et
- la teneur en Cr du substrat de bande d'acier est d'au moins 10 % (en poids),
**caractérisé en ce que**
le substrat de bande à une résistance à la traction minimale de 1000 MPa dans un état laminé à froid ou de traité thermiquement.

2. Procédé selon la revendication 1 **caractérisé en ce que** le substrat de bande a une résistance à la traction d'au moins 1300 Mpa.

3. Procédé selon la revendication 1 **caractérisé en ce que** le substrat de bande a une résistance à la traction d'au moins 1700 MPa.

4. Procédé selon l'une quelconque des revendications 1 à 3, **caractérisé en ce que** ledit substrat de bande est constitué d'acier inoxydable austénitique, ou d'acier inoxydable duplex, ou d'acier au chrome martensitique durcissable, ou d'acier inoxydable durcissable par précipitation, ou d'acier maraging.
